# EUROPÄISCHE PATENTSCHRIFT

(11) **EP 0 487 876 B1**
(45) Veröffentlichungstag und Bekanntmachung des Hinweises auf die Patenterteilung: **16.08.1995**
(21) Anmeldenummer: 91117415.9
(22) Anmeldetag: 11.10.1991
(51) Int. Cl.: H01S 3/085, H01S 3/103, H01L 27/15

(54) **Monolithisch integrierte Laserdiode-Wellenleiter-Kombination**
Monolithically integrated laserdiode-waveguide-combination
Combinaison d'une diode laser et d'un guide d'onde intégré monolithique

(30) Priorität: 28.11.1990 DE 4037896
(43) Veröffentlichungstag der Anmeldung: 03.06.1992
(73) Patentinhaber: SIEMENS AKTIENGESELLSCHAFT, 80333 München (DE)
(72) Erfinder: Thulke, Wolfgang, Dr., 81737 München (DE)

(56) Entgegenhaltungen:
- EP-A- 0 178 497
- EP-A- 0 360 011
- US-A- 4 352 116
- ELECTRONICS LETTERS, Bd. 26, Nr. 13, 21. Juni 1990, Stevenage, Herts, GB, SS. 933-934
- IEE PROCEEDINGS J. OPTOELECTRONICS Bd. 137, Nr. 1, Februar 1990, Stevenage, GB, SS. 69-73; C.F.J. SCHANEN et al.: 'Fabrication and lasing characteristics of lamda=1.56 mum tunable twin-guide (TTG) DFB laser'
- APPLIED PHYSICS LETTERS, Bd. 54, Nr. 2, 9. Januar 1989, NEW YORK US Seiten 114- 116; K.-Y LIOU ET AL: 'Monolithic integrated InGaAsP/InP distributed feedback laser with Y-branching waveguide and a monitoring photodetector grown by metalorganic chemical vapor deposition'

## Beschreibung

Die vorliegende Erfindung betrifft eine monolithisch integrierte Laserdiode-Wellenleiter-Kombination.

Eine monolithisch integrierte Kombination einer Laserdiode und eines damit verkoppelten passiven Wellenleiters wird bisher nur auf einem leitfähigen Substrat hergestellt. Ein für die Stromzufuhr vorgesehener Kontakt ist dabei auf der Unterseite des Substrates aufgebracht. In Electronics Letters 26, 933 - 934 (1990) ist eine Laserdiode auf semiisolierendem Substrat mit planarer Oberfläche beschrieben. Dabei ist eine streifenförmige aktive Schicht zwischen einer p-dotierten Schicht, die von der Oberseite des Bauelementes über ein p-diffundiertes Gebiet kontaktiert wird, und einer n-dotierten Schicht, in die über n-dotiertes Halbleitermaterial seitlich Strom geschickt werden kann, angeordnet. Dieses seitliche n-dotierte Halbleitermaterial wird auf der Oberfläche des Bauelementes, die eben ist, seitlich des aktiven Streifens kontaktiert.

In Electronics Letters 26, 458 - 459 (1990) ist eine Laserdiode auf semiisolierendem Substrat beschrieben, bei dem ein aktiver Streifen auf einer n-dotierten InP-Schicht längs des Randes verläuft. Seitlich dieses aktiven Streifens befindet sich ein n-Kontakt auf dieser InP-Schicht. Oberhalb des aktiven Streifens und auf der von dieser InP-Schicht nicht bedeckten Oberfläche ist eine p-dotierte Kontaktschicht aufgewachsen mit einem darauf befindlichen p-Kontakt.

In IEE Proceedings 137, 39 - 42 (1990) ist eine Laserdiode auf semiisolierendem Substrat beschrieben, bei der sich ein aktiver Streifen auf einer n-dotierten Schicht aus InP befindet, der von oben und seitlich in eine p-dotierte InP-Schicht eingebettet ist. Darauf befindet sich eine hoch p-leitend dotierte Kontaktschicht und darauf ein p-Kontakt. Die untere n-dotierte InP-Schicht ist seitlich mit einem n-Kontakt versehen. Ein ähnlicher Aufbau ist in IEE Proceedings 136, 76 - 82 (1989) beschrieben.

In Electronics Letters 24, 467 - 468 (1988) und in Journal of Lightwave Technology LT-4, 908 - 912 (1986) werden Laserdioden mit integriertem Feldeffekttransistor auf semiisolierendem Substrat beschrieben.

In IEE Proceedings 137, 69 - 73 (1990) wird ein abstimmbarer DFB-Laser beschrieben, bei dem vertikal eine aktive Schicht und eine Abstimmschicht angeordnet sind und die Stromzufuhr zu beiden Schichten über eine zentral dazwischen befindliche Schicht und seitlich vorhandenes Halbleitermaterial erfolgt. Die Kontakte sind auf einer dreilagigen streifenförmigen Schicht auf dem seitlichen Halbleitermaterial, auf einer Kontaktschicht anderer Zusammensetzung oberhalb des streifenförmigen aktiven Bereiches und auf der Unterseite des leitfähigen Substrates angeordnet.

Aufgabe der vorliegenden Erfindung ist es, eine monolithisch integrierte Laserdiode-Wellenleiter-Kombination auf semiisolierendem Substrat anzugeben.

Diese Aufgabe wird mit der Laserdiode-Wellenleiter-Kombination mit den Merkmalen des Anspruches 1 gelöst. Weitere Ausgestaltungen ergeben sich aus den Unteransprüchen.

Erfindungsgemäß erfolgt die Integration des Wellenleiters mit der Laserdiode auf semiisolierendem Substrat dadurch, daß die aktive Zone der Laserdiode auf den Seiten von einer dotierten Mantelschicht eingeschlossen ist, die die elektrische Verbindung zu Kontakten auf der Oberseite des Bauelementes herstellt. Halbleitermaterial, das für den entgegengesetzten Leitfähigkeitstyp dotiert ist, befindet sich als obere Mantelschicht in Form eines Steges oberhalb und längs der aktiven Schicht. Dieser von der oberen Mantelschicht gebildete Steg ist an seinem Fuß nicht wesentlich breiter als die aktive Schicht. Auf dem Steg ist die Metallisierung des anderen Kontaktes aufgebracht und über einen schmalen Streifen zu einer Bondfläche geführt. Diese Bondfläche ist auf dem passiven Abschnitt, d. h. dort, wo sich der optische Wellenleiter befindet, angeordnet. Eine besonders vorteilhafte Ausgestaltung des erfindungsgemäßen Aufbaues sieht vor, daß die optische Rückkopplung des Laserlichts in der Laserdiode durch ein DFB-Gitter erfolgt. Dieses DFB-Gitter kann über oder unter der aktiven Schicht liegen. Die erfindungsgemäße Laserdiode-Wellenleiter-Kombination kann mit allen bekannten Epitaxieverfahren hergestellt werden. Besonders geeignet erscheinen die gebräuchlichen Gasphasen-Verfahren MOVPE oder MOMBE.

Es folgt eine Beschreibung besonders vorteilhafter Ausführungsformen anhand der Figuren 1 bis 26.
- Fig. 1: zeigt die fertige Laserdiode-Wellenleiter-Kombination in einer Schnittaufsicht.
- Die Figuren 10 und 26: zeigen Ausführungsformen der erfindungsgemäßen Laserdiode-Wellenleiter-Kombination in einem Querschnitt.

Die restlichen Figuren zeigen Querschnitte oder Längsschnitte des erfindungsgemäßen Aufbaues nach verschiedenen Herstellungsschritten.

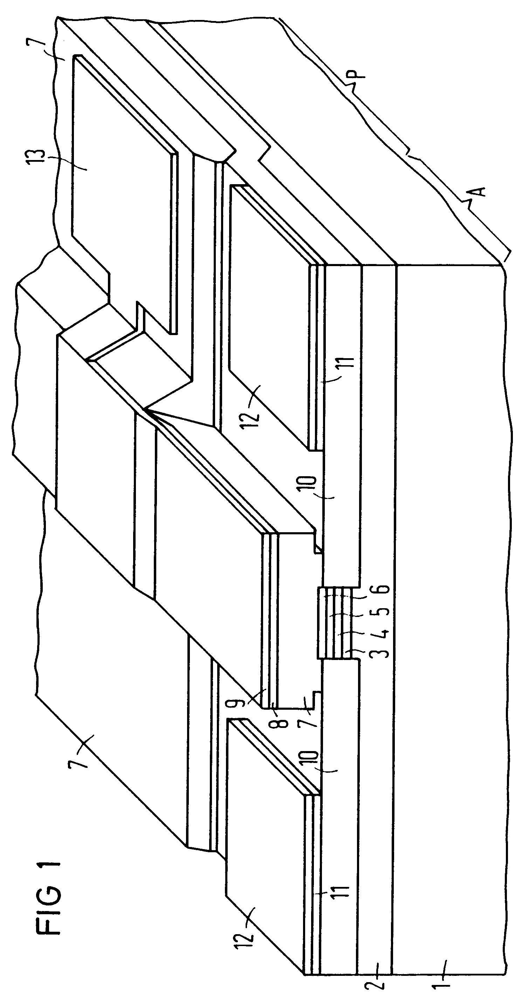

Fig. 1 Zeigt auf einem Substrat 1 eine Pufferschicht 2 und darauf streifenförmig übereinander angeordnet eine Wellenleiterschicht 3, eine Zwischenschicht 4, eine aktive Schicht 5 und eine Gitterschicht 6 mit dem darauf befindlichen Steg der oberen Mantelschicht 7, auf die eine zentrale Kontaktschicht 8 mit dem zentralen Kontakt 9 aufgebracht ist. Dieser zentrale Kontakt 9 ist seitlich mit der Bondfläche 13 elektrisch verbunden. Seitlich des die aktive Schicht 5 umfassenden Streifens ist die untere Mantelschicht 10 auf die Pufferschicht 2 aufgebracht. Darauf befindet sich die seitliche Kontaktschicht 11 mit dem darauf befindlichen seitlichen Kontakt 12. Die Materialien der oberen Mantelschicht 7 und der unteren Mantelschicht 10 sind entgegengesetzt zueinander dotiert. An den aktiven Bereich A schließt sich der passive Bereich P mit dem Wellenleiter an. In diesem passiven Bereich P ist die obere Mantelschicht 7 auch seitlich des mittleren Steges aufgewachsen. Die untere Mantelschicht 10 befindet sich in dem passiven Bereich P auch oberhalb des streifenförmigen Wellenleiters (die Verlängerung der Wellenleiterschicht 3 in Fig. 1).

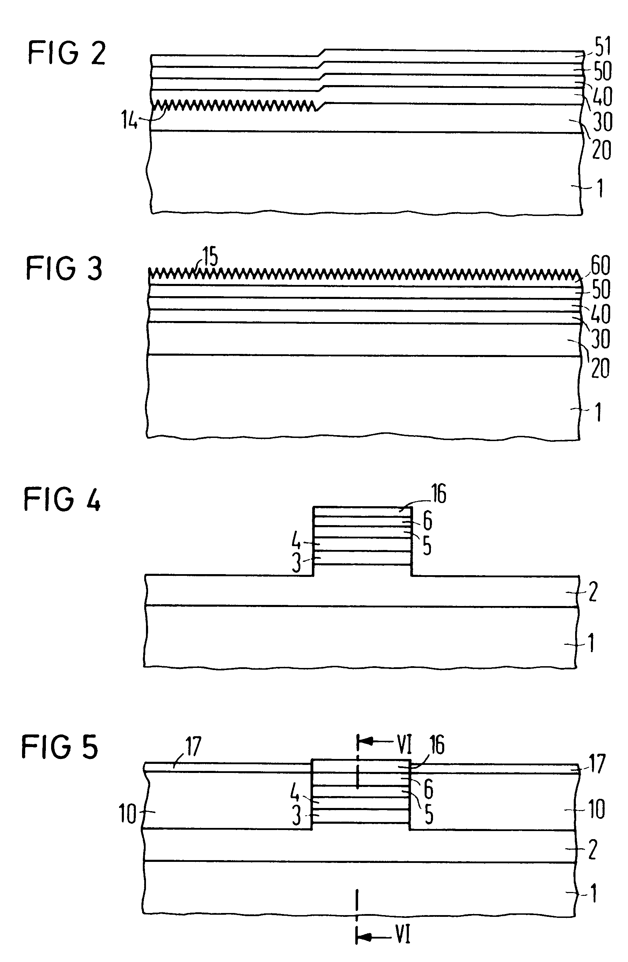

Die in Fig. 1 nicht vollständig erkennbare Struktur wird im folgenden für das Beispiel eines BH-Wellenleiters anhand des Herstellungsverfahrens beschrieben. Fig. 2 zeigt im Längsschnitt das semiisolierende Substrat 1 mit der darauf aufgewachsenen Pufferschicht 20, die auch entfallen kann, mit der darauf aufgewachsenen Zwischenschicht 40, der aktiven Schicht 50 und einer Schutzschicht 51. An der Grenze zwischen der Pufferschicht 20 bzw. der überwachsenen Oberseite des Substrates 1 und der nachfolgenden Wellenleiterschicht 30 befindet sich in dem aktiven Bereich ein Gitter 14. Das Substrat 1 kann z. B. InP:Fe und die Pufferschicht 20 InP sein. Die Pufferschicht 20 kann undotiert oder z. B. n-dotiert sein. Das Gitter muß lokal begrenzt hergestellt werden, da es nur in dem aktiven Bereich der Laserdiode benötigt wird und im passiven Bereich zu Abstrahlverlusten führen würde. Die Wellenleiterschicht ist undotiert oder z. E. n⁻-dotiert und z. B. InGaAsP der Wellenlänge 1,3 »m. Die Zwischenschicht 40 ist z. B. n⁺-dotiert und z. B. InP:Sn. Die aktive Schicht 50 ist undotiert und z. B. InGaAsP der Wellenlänge 1,55 »m. Die Schutzschicht 51 ist z. B. p-dotiert und InP:Zn.

Eine andere Ausgestaltung entsprechend Fig. 3 sieht vor, das Gitter 15 oberhalb der aktiven Schicht 50 anzuordnen. Die oberste Schicht als Gitterschicht 60 ist aus Material mit größerer Brechzahl als die Schutzschicht 51 in Fig. 2. Diese Gitterschicht 60 kann z. B. InGaAsP der Wellenlänge 1,15 »m sein. In diese Gitterschicht 60 ist das DFB-Gitter auf der ganzen Fläche eingeätzt. Nachfolgend werden die weiteren Herstellungsschritte und Strukturvarianten für diese Ausführungsform nach Fig. 3 mit dem oben angeordneten Gitter beschrieben, da diese Variante die herstellungstechnisch einfachere Lösung der Aufgabenstellung darstellt.

Als nächstes wird in dem passiven Bereich die Wellenleiterschicht 30 freigelegt, was durch herkömmliche Photolithographie und selektives naßchemisches Ätzen geschehen kann. Die Wellenleiterschicht 30 dient dabei als Ätzstoppschicht. Der BH-Steg im aktiven Bereich ist in Fig. 4 im Querschnitt dargestellt. Bei der Herstellung wird eine streifenförmige Maske 16 (z. B. SiO₂) auf die Oberfläche der Gitterschicht 60 aufgebracht. Diese Maske 16 wird für das Ätzen der Schichtfolge bis hinunter in die Pufferschicht 2 bzw. beim Fehlen der Pufferschicht bis in das Substrat 1 verwendet. Anschließend wird diese Maske 16 im passiven Bereich entfernt. Auf dem Gitter in der Gitterschicht 6 bleibt sie zunächst bestehen.

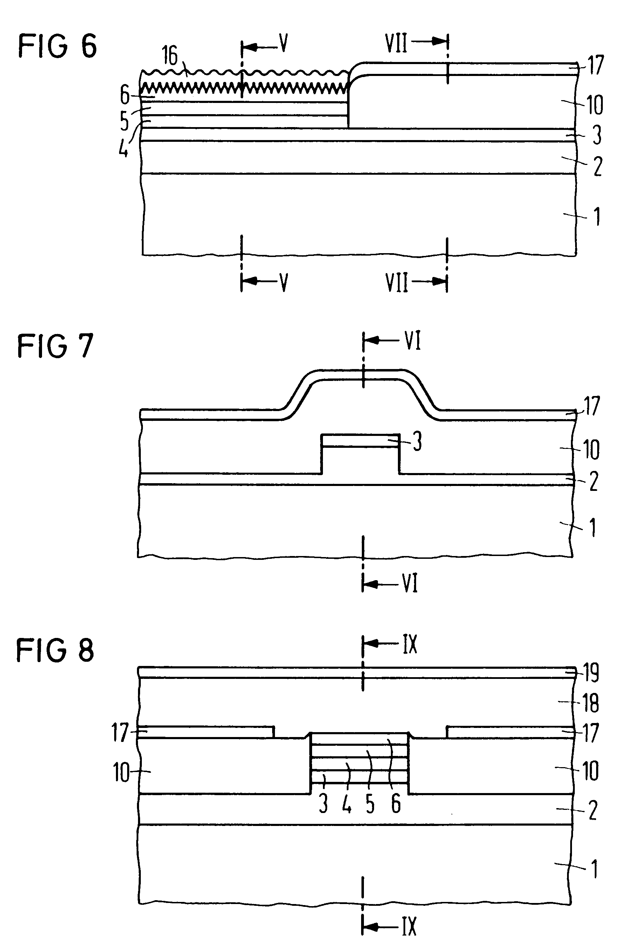

In einem nachfolgenden Epitaxieschritt werden die Flanken des Laserstegs mit einer unteren Mantelschicht 10 (z. B. n-dotiertes InP:Zn) bedeckt. Diese untere Mantelschicht wird im passiven Bereich auch über die Wellenleiterschicht 3 gewachsen. Im aktiven Bereich verhindert die Maske 16 aus Oxid das Überwachsen mit dem Halbleitermaterial der unteren Mantelschicht 10. Fig. 5 zeigt den Schichtaufbau nach dem Aufwachsen dieser unteren Mantelschicht 10 und einer ersten Kontaktschicht 17 (z. b. n⁺-dotieres InGaAs:Si), die die Kontakte mit später aufzubringenden Metallisierungen verbessert. Auf dem Substrat 1 befindet sich die seitlich teilweise abgeätzte Pufferschicht 2, in dem Steg die Wellenleiterschicht 3, die Zwischenschicht 4, die aktive Schicht 5, die Gitterschicht 6 und die streifenförmige Maske 16 aus Oxid. Der eingezeichnete Längsschnitt ist in Fig. 6 dargestellt. In dem passiven Bereich befindet sich auf der Wellenleiterschicht 3 unmittelbar die untere Mantelschicht 10 und darauf die erste Kontaktschicht 17. Der hier eingezeichnete Querschnitt im passiven Bereich ist in Fig. 7 dargestellt. Auf dem Substrat 1 ist eine hier seitlich stärker abgeätzte Pufferschicht 2 und auf deren mittlerem Steg die Wellenleiterschicht 3 als passiver optischer Wellenleiter dargestellt. Die untere Mantelschicht 10 ist ganzflächig, also auch auf diesem Steg aufgewachsen. Darauf befindet sich die erste Kontaktschicht 17.

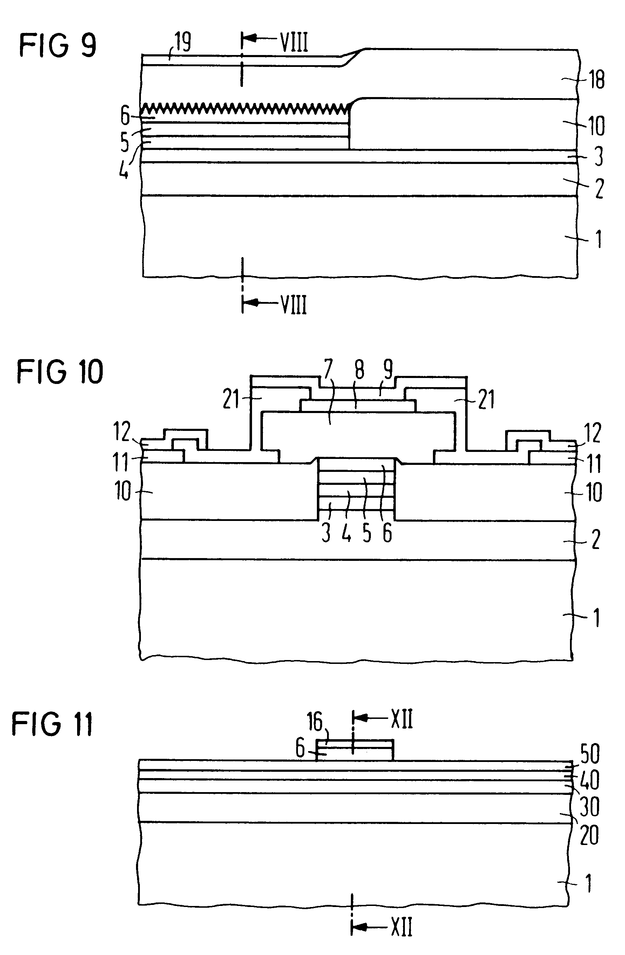

Die erste Kontaktschicht 17 wird anschließend im passiven Bereich und in zwei schmalen Streifen beidseits der Maske 16 entfernt. Danach wird die Maske 16 entfernt. In einem letzten Epitaxieschritt wird die obere Mantelschicht 18 (aus z. B. p-dotiertem InP:Zn) auf der gesamten Fläche aufgebracht. Diese obere Mantelschicht 18 muß sich in ihrer Brechzahl von der Gitterschicht 6 unterscheiden, da sie das Gitter überwächst und somit zur periodischen Variation der Brechzahl beiträgt. Auf die obere Mantelschicht 18 wird eine zweite Kontaktschicht 19 (z. B. p⁺-dotiertes InGaAs:Zn), die zur Verbesserung des Kontaktes einer darauf aufzubringenden Metallisierung dient, aufgebracht. Diese zweite Kontaktschicht 19 wird anschließend im passiven Bereich entfernt. Der in Fig. 8 eingezeichnete Längsschnitt ist in Fig. 9 dargestellt. Die obere Mantelschicht 18 ist im aktiven Bereich auf der Gitterschicht 6 und im passiven Bereich auf der unteren Mantelschicht 10 aufgebracht. Im aktiven Bereich befindet sich auf der oberen Mantelschicht 18 die zweite Kontaktschicht 19.

Die zweite Kontaktschicht 19 wird dann über dem Streifen der aktiven Schicht 5 zu einem Streifen strukturiert, der etwas breiter als der aktive Streifen 5 ist. Die von der zweiten Kontaktschicht 19 verbleibende zentrale Kontaktschicht 8 und deren Flanken werden mit einem Oxid bedeckt. Anschließend werden dieses Oxid und die obere Mantelschicht 18 mit einer selektiven Methode bis auf die seitliche Kontaktschicht 11 herabgeätzt. Über dem Streifen der aktiven Schicht 5 bleibt danach ein Steg der oberen Mantelschicht 7, der etwas breiter als die Lücke in den Anteilen der seitlichen Kontaktschicht 11 und etwas breiter als der auf dieser oberen Mantelschicht 7 aufgebrachte Streifen der zentralen Kontaktschicht 8 ist.

Die seitliche Kontaktschicht 11 wird ebenfalls in Streifenform geätzt, wobei ihre Anteile unter den Seiten der oberen Mantelschicht 7 herausgeätzt werden, so daß zwischen der oberen Mantelschicht 7 und den verbleibenden Anteilen der seitlichen Kontaktschicht 11 die Oberfläche der unteren Mantelschicht 10 in schmalen Streifen freigelegt ist. Die gesamte Oberfläche wird mit einem Dielektrikum 21 (Isolationsoxid) bedeckt, das über den Streifen der zentralen Kontaktschicht 8 und der seitlichen Kontaktschicht 11 wieder entfernt wird. Abschließend wird eine Kontaktmetallisierung aufgedampft, die in einem letzten Photolithographieschritt in geeignete Form gebracht wird, so daß ein zentraler Kontakt 9 auf der zentralen Kontaktschicht 8 und davon elektrisch isoliert ein seitlicher Kontakt 12 auf der seitlichen Kontaktschicht 11 hergestellt werden. Der zentrale Kontakt 9 ist in dem vorliegenden Ausführungsbeispiel der p-Kontakt, der (zweiteilige) seitliche Kontakt 12 auf der (zweiteiligen) seitlichen Kontaktschicht 11 der n-Kontakt. Ein Querschnitt durch den fertigen aktiven Bereich dieses Ausführungsbeispiels zeigt Fig. 10.

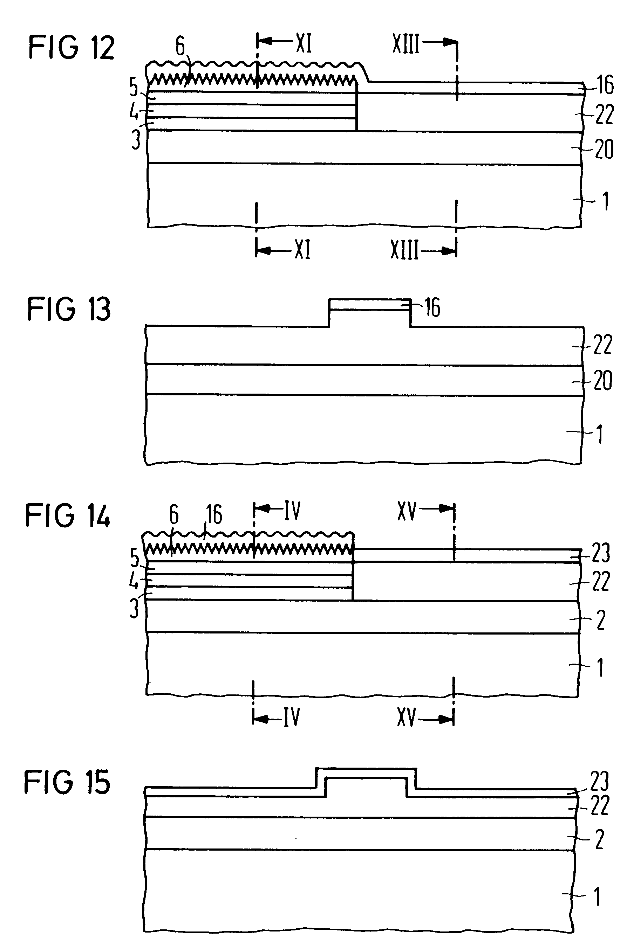

Ein weiteres Ausführungsbeispiel mit vergrabenem Rippenwellenleiter wird im folgenden beschrieben. Dieses Ausführungsbeispiel geht auch von der Struktur nach Fig. 2 bzw. nach Fig. 3 aus. Die Wellenleiterschicht 30 hat hier aber nur die Funktion einer Ätzstoppschicht. Sie kann daher dünner sein als im vorhergehenden Ausführungsbeispiel. Im passiven Bereich wird die Schichtfolge bis einschließlich der Wellenleiterschicht 30 entfernt. Anschließend wird in dem passiven Bereich, in dem die Oberfläche der Pufferschicht 20 bzw., falls keine Pufferschicht vorhanden ist, des Substrates 1 freigelegt ist, eine undotierte Wellenleiterschicht 22 (z. B. InGaAsP der Wellenlänge 1,05 »m) epitaktisch aufgewachsen. Dabei wird der aktive Bereich durch ein Oxid (SiO₂) abgedeckt, das das epitaktische Wachstum dort verhindert. Nachdem die Wellenleiterschicht 22 aufgewachsen ist, wird auch diese mit Oxid bedeckt, das über die gesamte Länge zu einem schmalen Streifen strukturiert wird. Dieser Oxidstreifen dient als Maske 16 für das Ätzen der Rippe im Wellenleiter. Gleichzeitig definiert er den Lasersteg, der im anschließenden Schritt geätzt wird. Fig. 11 zeigt einen Querschnitt im aktiven Bereich mit der Maske 16 und der streifenförmig geätzten Gitterschicht 6 auf der ganzflächigen aktiven Schicht 50. Der eingezeichnete Längsschnitt ist in Fig. 12 dargestellt. Die Wellenleiterschicht 22 schließt sich an die Schichtfolge aus Wellenleiterschicht 3 (Ätzstoppschicht), Zwischenschicht 4, aktiver Schicht 5 und Gitterschicht 6 an. Der eingezeichnete Querschnitt im passiven Bereich ist in Fig. 13 dargestellt. Im passiven Bereich ist in die Wellenleiterschicht 22 mittels der Maske 16 ein Steg (Rippenwellenleiter) geätzt. Nach dem Ätzen dieser Rippe wird die Maske 16 im passiven Bereich entfernt. In diesem Bereich wird eine weitere Maske 23 (Oxid, z. B. Al₂O₃) aufgebracht. Das Material dieser weiteren Maske 23 muß selektiv gegen das Material der ersten Maske 16 geätzt werden können. Die weitere Maske 23 schützt die Wellenleiterrippe beim Ätzen des Laserstegs. Die betreffende Struktur ist in den Figuren 14 und 15 dargestellt. Der in Fig. 14 eingezeichnete Querschnitt im passiven Bereich ist in Fig. 15 mit der dort ganzflächig aufgebrachten weiteren Maske 23 dargestellt. Der in Fig. 14 eingezeichnete Querschnitt im aktiven Bereich entspricht Fig. 4 des vorhergehenden Ausführungsbeispiels.

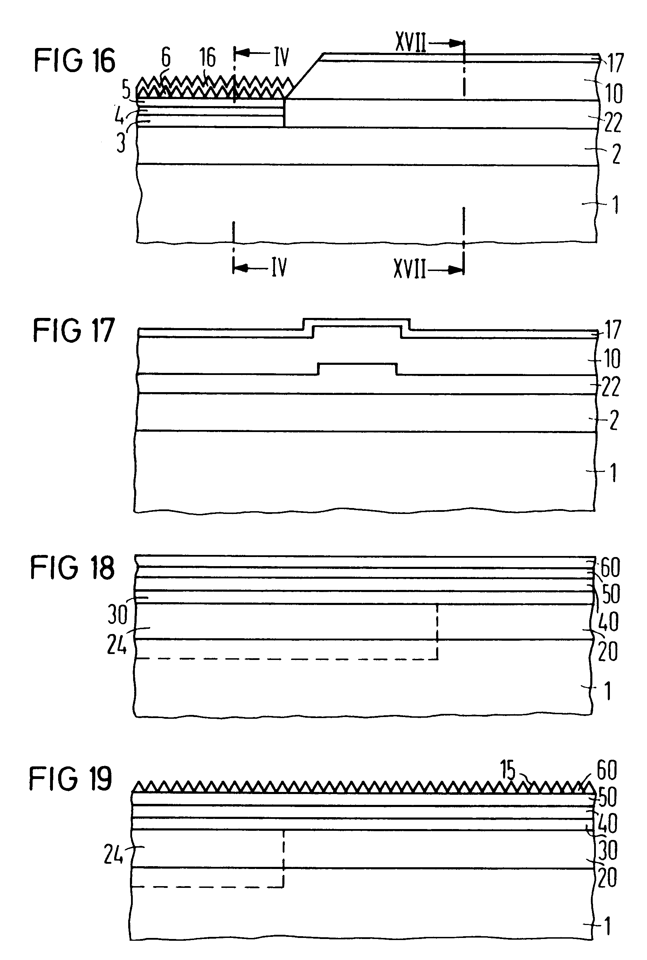

Die weitere Maske 23 wird entfernt, und die untere Mantelschicht 10 sowie die erste Kontaktschicht 17 werden epitaktisch aufgewachsen. Dabei verhindert die auf dem Lasersteg verbliebene Maske 16 das epitaktische Aufwachsen dieser Schichten auf dem Lasersteg. Fig. 16 zeigt den der Figur 6 des ersten Ausführungsbeispieles entsprechenden Längsschnitt. Der eingezeichnete Querschnitt im aktiven Bereich entspricht wieder der Fig. 4 des ersten Ausführungsbeispieles. Der eingezeichnete Querschnitt im passiven Bereich ist in Fig. 17 dargestellt. In Fig. 17 ist über der Wellenleiterschicht 22 mit der darin ausgeätzten Rippe ganzflächig die untere Mantelschicht 10 und darauf die erste Kontaktschicht 17 aufgewachsen. Wie in dem ersten Ausführungsbeispiel wird die erste Kontaktschicht 17 in dem passiven Bereich und in schmalen Streifen beidseits der Maske 16 entfernt. Danach wird die Maske 16 ebenfalls entfernt. Die obere Mantelschicht 18 und die zweite Kontaktschicht 19 werden ganzflächig aufgewachsen. Anschließend werden diese Schichten wie in dem ersten Ausführungsbeispiel zu der oberen Mantelschicht 7, der zentralen Kontaktschicht 8 und der seitlichen Kontaktschicht 11 rückgeätzt. Das Dielektrikum 21 und der zentrale Kontakt 9 sowie der seitliche Kontakt 12 werden wie in dem ersten Ausführungsbeispiel aufgebracht. Der aktive Bereich unterscheidet sich nicht gegenüber dem ersten Ausführungsbeispiel, während in dem passiven Bereich bei diesem zweiten Ausführungsbeispiel der Wellenleiter nicht als Verlängerung der Wellenleiterschicht 3 sondern als Rippenwellenleiter in der Wellenleiterschicht 22 ausgebildet ist.

In der erfindungsgemäßen Laserdiode-Wellenleiter-Kombination kann auch die in der letzten zum Stand der Technik genannten Veröffentlichung in LEE Proceedings 137, 69 - 73, beschriebene TTG-DFB-Laserdiode integriert sein. Diese Laserdiode besitzt einen elektronisch ansteuerbaren Wellenleiter über oder unter der aktiven Schicht. Im folgenden wird die Herstellung eines Ausführungsbeispiels beschrieben, bei dem diese Abstimmschicht unterhalb der aktiven Schicht liegt und als passiver Wellenleiter außerhalb des Laserbereichs, d. h. in dem passiven Bereich, weiterläuft. Die Herstellung dieses Ausführungsbeispieles gleicht daher in vielen Punkten der des ersten Ausführungsbeispiels. Andere Wellenleiterformen, wie z. B. der Rippenwellenleiter des zweiten Ausführungsbeispieles, können ebenfalls mit dieser TTG-DFB-Laserdiode zu der erfindungsgemäßen Kombination integriert werden. Im Fall des Rippenwellenleiters sind für das Herstellungsverfahren die dem zweiten Ausführungsbeispiel entsprechenden Veränderungen vorzunehmen.

Im folgenden wird die Kombination der TTG-DFB-Laserdiode mit dem Wellenleiter des ersten Ausführungsbeispiels als weiteres Ausführungsbeispiel beschrieben. Für die Stromzuführung in eine Abstimmschicht ist eine zusätzliche Dotierung erforderlich. Diese Dotierung erfolgt vorteilhaft vor dem Aufwachsen der restlichen Schichtfolge in die auf das Substrat 1 aufgewachsene Pufferschicht 20 bzw., falls keine Pufferschicht 20 aufgewachsen wird, direkt in das Substrat 1. Das Vorzeichen der Dotierung ist dasselbe wie das der oberen Mantelschicht, im vorliegenden Ausführungsbeispiel p-Leitung. Es werden dann die Wellenleiterschicht 30 als Abstimmschicht, die Zwischenschicht 40, die aktive Schicht 50 und die Gitterschicht 60 aufgewachsen. In Fig. 18 ist diese Schichtfolge im Querschnitt gezeigt und der dotierte Bereich 24 durch gestrichelte Linien dargestellt. Die Implantation oder Diffusion von Dotierstoff ist lokal begrenzt, d. h. der dotierte Bereich 24 befindet sich unterhalb des von dem Laserstreifen einzunehmenden Bereiches und auf einer Seite davon. Die andere Seite bleibt undotiert. Fig. 19 zeigt einen Längsschnitt mit dem in der Gitterschicht 60 hergestellten Gitter 15. Der dotierte Bereich 24 ist auf den aktiven Bereich begrenzt.

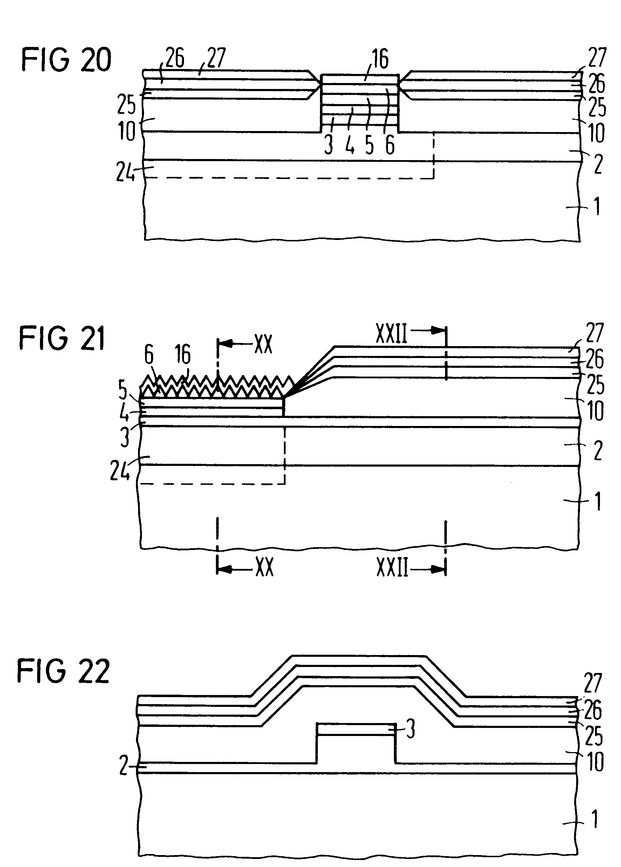

Wie im ersten Ausführungsbeispiel werden im passiven Bereich die Gitterschicht 60, die aktive Schicht 50 und die Zwischenschicht 40 entfernt und die Schichtfolge im aktiven Bereich zu dem in Fig. 4 im Querschnitt dargestellten Lasersteg rückgeätzt, wobei wieder eine Maske 16 Verwendung findet. Dann wird die untere Mantelschicht 10 entsprechend Fig. 5 und Fig. 6 aufgewachsen. Die erste Kontaktschicht wird in diesem Ausführungsbeispiel vorteilhaft aus einer dreiteiligen Schichtfolge bestehen. Eine erste Teil-Kontaktschicht 25 ist niedrig dotiert für, in diesem Ausführungsbeispiel, n-Leitung. Darauf folgt eine zweite Teil-Kontaktschicht 26 anderer Zusammensetzung (z. B. InP:Zn) und darauf eine dritte Teil-Kontaktschicht 27, die hoch dotiert ist. Die erste und die dritte Teil-Kontaktschicht 25, 27 können aus dem gleichen Material sein, die Materialien können aber auch verschieden sein, wie in der zitierten Druckschrift angegeben (erste Teil-Kontaktschicht 25 z. B. n-InGaAsP, zweite Teil-Kontaktschicht 26 n-InP, dritte Teil-Kontaktschicht 27 n⁺-InGaAs). Fig. 20 zeigt den Querschnitt im Bereich der Laserdiode mit dem Substrat 1, der Pufferschicht 2, dem dotierten Bereich 24, der Wellenleiterschicht 3 als Abstimmschicht, der Zwischenschicht 4, der aktiven Schicht 5, der Gitterschicht 6, der Maske 16, der unteren Mantelschicht 10 und den drei Teil-Kontaktschichten 25, 26, 27. Einen Längsschnitt zeigt Fig. 21 und einen Querschnitt im passiven Bereich Fig. 22.

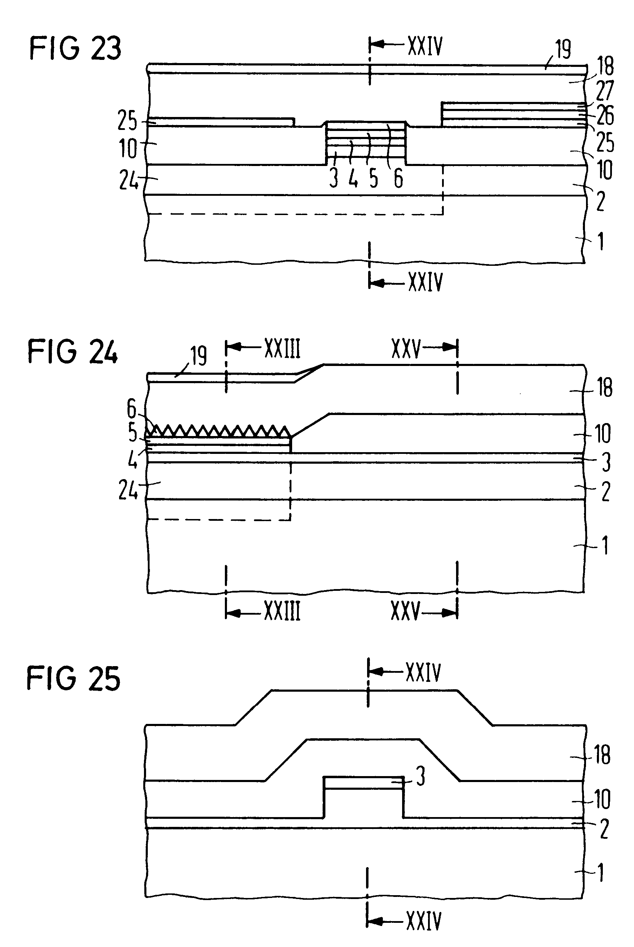

Die Maske 16 wird entfernt und die erste Kontaktschicht auf streifenförmige Bereiche im aktiven Bereich rückgeätzt. Zusätzlich werden auf der Seite des dotierten Bereiches 24 die Anteile der zweiten und dritten Teil-Kontaktschicht 26, 27 entfernt, so daß in diesem Bereich nur der betreffende Anteil der ersten Teil-Kontaktschicht 25 stehen bleibt. Dann werden die obere Mantelschicht 18 und die zweite Kontaktschicht 19 aufgewachsen. Den Längsschnitt nach diesem Herstellungsschritt zeigt Fig. 24. Fig. 25 zeigt den Querschnitt im passiven Bereich.

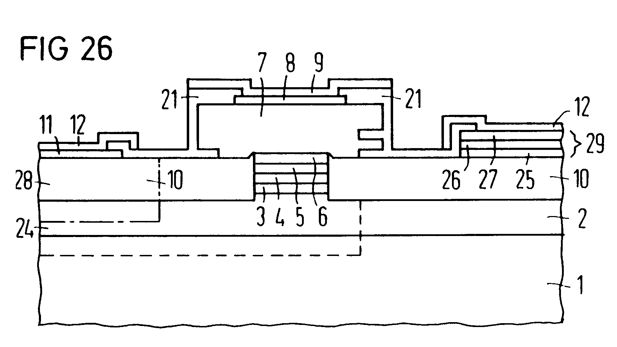

Nachdem die obere Mantelschicht 7 zu dem Streifen entsprechend dem ersten Ausführungsbeispiel heruntergeätzt ist, liegen die Oberflächen der seitlichen Kontaktschicht 11, 29 frei. Auf der oberhalb des dotierten Bereiches 24 befindlichen Seite besteht diese seitliche Kontaktschicht 11 nur aus dem betreffenden Anteil der ersten Teil-Kontaktschicht 25. Auf der anderen Seite ist die seitliche Kontaktschicht 29 aus drei Schichtanteilen 25, 26, 27 zusammengesetzt. Der Anteil der seitlichen Kontaktschicht 11 über dem dotierten Bereich 24 und der darunter befindliche Anteil der unteren Mantelschicht 10 werden durch Implantation oder Diffusion mit Dotierstoff umdotiert, so daß das Halbleitermaterial dieselbe Leitfähigkeit wie der dotierte Bereich 24 darunter besitzt. Auf der seitlichen Kontaktschicht 11 wird ein seitlicher Kontakt 12 aufgebracht. Über diesen seitlichen Kontakt 12 kann auf der Seite der dreilagigen seitlichen Kontaktschicht 29 Strom über die Zentralschicht 4 zum Ansteuern der aktiven Schicht 5 und der Wellenleiterschicht 3 zugeführt werden. Der zweite Kontakt für die aktive Schicht 5 befindet sich als zentraler Kontakt 9 auf der zentralen Kontaktschicht 8. Der zweite Kontakt für die Wellenleiterschicht 3 als Abstimmschicht wird durch den anderen Anteil des seitlichen Kontaktes 12 auf der seitlichen Kontaktschicht 11 auf dem zweiten dotierten Bereich 28 gebildet. Die Stromzufuhr erfolgt über diesen zweiten dotierten Bereich 28 in der unteren Mantelschicht 10 und den anfangs hergestellten dotierten Bereich 24 in der Pufferschicht 2, wie in Fig. 26 im Querschnitt dargestellt ist. Im übrigen entspricht der Aufbau dem Ausführungsbeispiel nach Fig. 1.

Die erfindungsgemäße Laserdiode-Wellenleiter-Kombination ermöglicht die monolithische Integration einer Laserdiode mit einem Wellenleiter auf semiisolierendem Substrat, wobei für die Laserdiode verschiedene Ausführungsformen, insbesondere abstimmbare Laserdioden, in Frage kommen. Die Bondflächen der Kontakte finden auf der Oberfläche dieser Laserdiode-Wellenleiter-Kombination Platz, und die erfindungsgemäße Struktur ist einfach herstellbar.

## Patentansprüche

1. Monolithisch integrierte Laserdiode-Wellenleiter-Kombination auf einem semiisolierenden Substrat (1) mit einer überwachsenen Hauptseite,
bei der eine passive Wellenleiterschicht (3) mit einer streifenförmigen aktiven Schicht (5) der Laserdiode verkoppelt ist,
bei der auf der dem Substrat (1) abgewandten Seite dieser aktiven Schicht (5) eine streifenförmige und für elektrische Leitung eines ersten Leitungstyps dotierte obere Mantelschicht (7) als Steg mit einer auf der Oberseite dieses Steges aufgebrachten zentralen Kontaktschicht (8) vorhanden ist, bei der dieser von dieser oberen Mantelschicht (7) gebildete Steg an seinem Fuß nicht wesentlich breiter als die aktive Schicht (5) ist,
bei der auf der dem Substrat (1) zugewandten Seite der aktiven Schicht (5) eine für elektrische Leitung eines entgegengesetzten zweiten Leitungstyps dotierte streifenförmige Zwischenschicht (4), die durch zwei zu der Hauptseite des Substrats (1) parallele Hauptseiten und zwei Längsseiten und zwei Schmalseiten begrenzt ist, vorhanden ist,
bei der eine untere Mantelschicht (10) vorhanden ist, die im Bereich der Laserdiode an die beiden Langsseiten dieser Zwischenschicht (4) angrenzt und mindestens auf einer Seite der Zwischenschicht (4) für elektrische Leitung des zweiten Leitungstyps dotiert ist,
bei der auf diese untere Mantelschicht (10) eine seitliche Kontaktschicht (11) aufgebracht ist und
bei der auf die zentrale Kontaktschicht (8) ein zentraler Kontakt (9) und auf die seitliche Kontaktschicht (11) ein seitlicher Kontakt (12) aufgebracht ist.

2. Laserdiode-Wellenleiter-Kombination nach Anspruch 1,
bei der für die optische Rückkopplung des Laserlichts ein DFB-Gitter vorhanden ist, das in einer zwischen der oberen Mantelschicht (7) und der aktiven Schicht (5) angeordneten Gitterschicht (6) ausgebildet ist.

3. Laserdiode-Wellenleiter-Kombination nach Anspruch 1,
bei der für die optische Rückkopplung des Laserlichts ein DFB-Gitter zwischen der Zwischenschicht (4) und dem Substrat (1) vorhanden ist.

4. Laserdiode-Wellenleiter-Kombination nach einem der Ansprüche 1 bis 3,
bei der die untere Mantelschicht (10) auf einer Seite der Zwischenschicht (4) für elektrische Leitung des ersten Leitungstyps dotiert ist,
bei der auf der dem Substrat (1) zugewandten Seite der Zwischenschicht (4) eine Abstimmschicht (3) vorhanden ist,
bei der ein für elektrische Leitung des ersten Leitungstyps dotierter Bereich (24) vorhanden ist, der an die dem Subtrat (1) zugewandte Hauptseite dieser Abstimmschicht (3) angrenzt und mit dem für den ersten Leitungstyp dotierten Anteil der unteren Mantelschicht (10) verbunden ist,
bei der die seitliche Kontaktschicht (11) einen Anteil auf dem für den ersten Leitungstyp dotierten Anteil der unteren Mantelschicht (10) und einen davon getrennten Anteil auf dem für den zweiten Leitungstyp dotierten Anteil der unteren Mantelschicht (10) hat und
bei der diese getrennten Anteile der seitlichen Kontaktschicht (11) jeweils mit einem separaten seitlichen Kontakt (12) versehen sind.

5. Laserdiode-Wellenleiter-Kombination nach Anspruch 4,
bei der die Anteile der seitlichen Kontaktschicht (11), oie auf den für verschiedene Leitungstypen dotierten Anteilen der unteren Mantelschicht (10) aufgebracht sind, zumindest in den jeweils obersten, mit dem betreffenden seitlichen Kontakt (12) versehenen Schichtanteilen voneinander verschiedene Materialzusammensetzungen aufweisen.

6. Laserdiode nach einem der Ansprüche 1 bis 5,
bei der der erste Leitungstyp p-Leitung und der zweite Leitungstyp n-Leitung ist und
bei der zumindest ein an den zentralen Kontakt (9) angrenzender Schichtanteil der zentralen Kontaktschicht (8) p⁺-leitend dotiert ist und zumindest ein an den für den n-leitend dotierten Anteil der unteren Mantelschicht (10) vorgesehenen seitlichen Kontakt (12) angrenzender Schichtanteil der seitlichen Kontaktschicht (11) n⁺-leitend dotiert ist.

## Claims

1. Monolithically integrated laser diode waveguide combination on a semi-insulating substrate (1) with a grown-over main side,
in which a passive waveguide layer (3) is coupled to a strip-shaped active layer (5) of the laser diode,
in which there is present on that side of this active layer (5) facing away from the substrate (1) a strip-shaped upper covering layer (7), doped for electrical conductivity of a first conductivity type, as a web having a central contact layer (8) applied on the upper side of this web,
in which the web formed by this upper covering layer (7) is not significantly wider at its foot than the active layer (5),
in which there is present on that side of the active layer (5) facing the substrate (1) a strip-shaped intermediate layer (4), doped for electrical conductivity of an opposing, second conductivity type, which is bounded by two main sides parallel to the main side of the substrate (1) and by two long sides and two narrow sides, in which there is present a lower covering layer (10), which is adjacent to the two long sides of this intermediate layer (4) in the region of the laser diode and is doped for electrical conductivity of the second conductivity type on at least one side of the intermediate layer (4),
in which there is applied on this lower covering layer (10) a lateral contact layer (11) and
in which there is applied on the central contact layer (8) a central contact (9) and on the lateral contact layer (11) a lateral contact (12).

2. Laser diode waveguide combination according to Claim 1, in which there is present, for the optical feedback of the laser light, a DFB grating, which is constructed in a grating layer (6) arranged between the upper covering layer (7) and the active layer (5).

3. Laser diode waveguide combination according to Claim 1, in which there is present, for the optical feedback of the laser light, a DFB grating between the intermediate layer (4) and the substrate (1).

4. Laser diode waveguide combination according to one of Claims 1 to 3,
in which the lower covering layer (10) on one side of the intermediate layer (4) is doped for electrical conductivity of the first conductivity type,
in which there is present on that side of the intermediate layer (4) facing the substrate (1) a tuning layer (3),
in which there is present a region (24) doped for electrical conductivity of the first conductivity type, which adjoins the main side, of this tuning layer (3), facing the substrate (1) and is connected to that portion of the lower covering layer (10) doped for the first conductivity type,
in which the lateral contact layer (11) has a portion on that portion of the lower covering layer (10) doped for the first conductivity type and a portion, separated therefrom, on that portion of the lower covering layer (10) doped for the second conductivity type and
in which these separate portions of the lateral contact layer (11) are provided in each case with a separate lateral contact (12).

5. Laser diode waveguide combination according to Claim 4, in which the portions of the lateral contact layer (11) which are applied on those portions of the lower covering layer (10) doped for different conductivity types have, at least in the respective uppermost layer portions provided with the relevant lateral contact (12), material compositions differing from each other.

6. Laser diode according to one of Claims 1 to 5, in which the first conductivity type is p-conductivity and the second conductivity type is n-conductivity and in which at least one layer portion, of the central contact layer (8), adjoining the central contact (9) is doped for p⁺-conductivity and at least one layer portion, of the lateral contact layer (11), adjoining the lateral contact (12) provided for the n-conductively doped portion of the lower covering layer (10), is doped for n⁺-conductivity.

## Revendications

1. Ensemble combiné diode laser - guide d'ondes à intégration monolithique sur un substrat semi-isolant (1) comportant une face principale surélevée, dans lequel
une couche passive formant guide d'ondes (3) est couplée à une couche active en forme de bande (5) de la diode laser,
une couche de revêtement supérieure (7), réalisée en forme de bande et dopée pour obtenir une conduction électrique d'un premier type, est prévue sous la forme d'une barrette possédant une couche centrale de contact (8) déposée sur la surface de cette barrette, et disposée sur la face de cette couche active (5), tournée à l'opposé du substrat (1),
cette barrette formée par cette couche de revêtement supérieure (7) est nettement plus large, au niveau de son pied, que la couche active (5),
une couche intermédiaire en forme de bande (4) dopée de manière à produire une conduction électrique avec un second type de conduction opposé et qui est limitée par deux faces principales, qui sont parallèles à la face principale du substrat (1) et par deux côtés longitudinaux et deux petits côtés, est disposée sur la face, tournée vers le substrat (1), de la couche active (5),
il est prévu une couche de revêtement inférieure (10), qui, dans la zone de la diode laser, jouxte les deux côtés longitudinaux de cette couche intermédiaire (4) et est dopée au moins sur une face de la couche intermédiaire (4), pour produire une conduction électrique du second type,
une couche latérale de contact (4) est déposée sur cette couche de revêtement inférieure (10), et
un contact central (9) est disposé sur la couche centrale de contact (8), et un contact latéral (12) est disposé sur la couche latérale de contact (11).

2. Ensemble combiné diode laser - guide d'ondes suivant la revendication 1, dans lequel, pour le couplage optique de réaction de la lumière laser, il est prévu un réseau DFB, qui est formé dans une couche de réseau (6) disposée entre la couche de revêtement supérieure (16) et la couche active (5).

3. Ensemble combiné diode laser - guide d'ondes suivant la revendication 1, dans lequel, pour le couplage optique à réaction de la lumière laser, un réseau DFB est disposé entre la couche intermédiaire (4) et le substrat (1).

4. Ensemble combiné diode laser - guide d'ondes suivant l'une des revendications 1 à 3, dans lequel
la couche de revêtement inférieure (10), sur une face de la couche intermédiaire (4), est dopée de manière à produire une conduction électrique du premier type,
sur la face de la couche intermédiaire (4), tournée vers le substrat (1), est disposée une couche de réglage d'accord (3), dans laquelle est présente une zone (24) dopée pour produire une conduction électrique du premier type et qui jouxte la face principale, tournée vers le substrat (1), de cette couche de réglage d'accord (3) et est reliée à la partie, dopée pour produire le premier type de conduction, de la couche de revêtement inférieur (10);
la couche latérale de contact (11) possède une partie située sur la partie, dopée pour produire le premier type de conduction, de la couche de revêtement inférieure (10) et une partie, qui en est séparée, située sur la partie, dopée pour produire le second type de conduction, de la couche de revêtement inférieure (10), et
ces parties séparées de la couche latérale de contact (11) sont pourvues chacune d'un contact latéral séparé (11).

5. Ensemble combiné diode laser - guide d'ondes suivant la revendication 4, dans lequel les parties de la couche latérale de contact (11), qui sont déposées sur les parties, dopées pour produire différents types de conduction, de la couche de revêtement inférieure (10), possèdent, au moins dans les parties respectivement les plus élevées de la couche, qui sont équipées du contact latéral considéré (12), de compositions de matériaux qui diffèrent les unes des autres.

6. Ensemble combiné diode laser - guide d'ondes suivant l'une des revendications 1 à 5, dans laquelle
le premier type de conduction correspond à la conduction du type p et le second type de conduction correspond à la conduction du type n, et
au moins une partie, qui jouxte le contact central (9), de la couche centrale de contact (8) est dopée de manière à être conductrice du type p⁺, et au moins une partie, qui jouxte la partie de la couche latérale de contact (11), qui jouxte le contact latéral (12), qui est prévu pour la partie, dopée de manière à être conductrice du type n, de la couche de revêtement inférieure (10), est dopée de manière à être conductrice du type n⁺.
